## Europäisches Patentamt
## European Patent Office
## Office européen des brevets

(19)

(11) Numéro de publication : **0 091 072 B1**

(12) **FASCICULE DE BREVET EUROPÉEN**

(45) Date de publication du fascicule du brevet :
**21.01.87**

(51) Int. Cl.⁴ : **H 01 L 21/56, H 01 L 23/30**

(21) Numéro de dépôt : **83103114.1**

(22) Date de dépôt : **29.03.83**

(54) Procédé d'encapsulation de composants semi-conducteurs, et composants encapsulés obtenus.

(30) Priorité : **01.04.82 FR 8205624**

(43) Date de publication de la demande :
**12.10.83 Bulletin 83/41**

(45) Mention de la délivrance du brevet :
**21.01.87 Bulletin 87/04**

(84) Etats contractants désignés :
**CH DE FR GB IT LI NL SE**

(56) Documents cités :
**DE-A- 2 543 968**
**DE-A- 2 806 567**
**GB-A- 1 552 144**
**GB-A- 2 046 024**
**US-A- 3 371 148**
**US-A- 3 739 462**
**US-A- 3 924 323**
**US-A- 3 959 874**
**US-A- 4 237 607**

(73) Titulaire : **ALCATEL**
**12, rue de la Baume**
**F-75008 Paris (FR)**

(72) Inventeur : **Roche, Georges**
**1 Villa Suzanne**
**F-92320 Chatillon Sous Bagneux (FR)**
Inventeur : **Lantaires, Jacques**
**10bis, Allée de la Tournelle**
**F-91370 Verrières le Buisson (FR)**

(74) Mandataire : **Weinmiller, Jürgen et al**
**Lennéstrasse 9**
**D-8133 Feldafing (DE)**

EP 0 091 072 B1

## Description

La présente invention a pour objet un procédé d'encapsulation de composants semi-conducteurs, notamment de composants de grande complexité et les composants encapsulés obtenus.

L'encapsulation de composants semi-conducteurs de grande complexité est un élément important de la fabrication des circuits intégrés dans la mesure où les techniques utilisées sont souvent coûteuses, notamment si la production envisagée ne porte pas sur des séries suffisantes. Ceci est par exemple le cas de la technique de report de pastilles sur support-film dite TAB.

Le principal problème posé est la réalisation des connexions permettant de relier les circuits intégrés avec l'extérieur, dans la mesure où l'on recherche à augmenter le nombre de connexions possibles en réduisant au maximum la taille du composant unitaire fabriqué. Or ce sont les nécessaires connexions avec l'extérieur qui exigent le plus de place, car on ne sait pas les réduire aux dimensions de celles qui sont mises en œuvre à l'intérieur des circuits intégrés qu'elles desservent.

En effet, si l'on reporte les pastilles par soudage sur un réseau métallique de connexion réalisé à partir d'une feuille métallique, les contraintes mécaniques de tenue du réseau avant soudage limitent la réduction des dimensions des pattes de connexion.

Si par contre il est possible de réaliser un réseau de connexion de très petites dimensions sur un substrat par différentes techniques usuelles en microélectronique, telles que dépôt sélectif à travers un masque, ou photolithographie additive ou éventuellement soustractive si le substrat a été préalablement revêtu d'une couche métallique, on ne sait pas séparer le réseau de connexion du substrat isolant qui le porte et l'on ne peut donc utiliser le réseau de connexion ainsi formé sauf à placer les connexions du même côté que la pastille, ce qui n'est pas le but recherché.

La présente invention a donc pour objet un procédé d'encapsulation de composants semi-conducteurs et notamment de composants de grande complexité permettant la production de composants encapsulés ayant un réseau de connexion de très petites dimensions.

Selon une caractéristique de l'invention les connexions destinées à relier chaque composant avec l'extérieur sont réalisées sous forme d'un réseau métallique disposé sur une couche conductrice d'alliage à bas point de fusion qui recouvre un substrat métallique temporaire, après mise en place et, raccordement de chaque composant puis immobilisation au moyen d'une résine durcissable, le retrait du substrat temporaire par fusion de la couche d'alliage met à jour les faces des zones des connexions qui sont destinées à la mise en liaison électrique et/ou thermique des composants avec l'extérieur.

De plus les composants encapsulés, selon le procédé objet de l'invention, qui comportent chacun au moins une pastille immobilisée dans une résine durcie avec ses fils de liaison à des zones de connexion métalliques et coplanaires destinées à assurer sa mise en liaison avec l'extérieur, comportent également un substrat métallique temporaire de protection lié aux zones métalliques de connexion par une couche d'alliage à bas point de fusion dont la fusion permet de retirer le substrat temporaire et de mettre à jour les faces des zones de connexion qui sont destinées à la mise en liaison électrique et/ou thermique avec l'extérieur.

La figure 1 présente une vue en arraché partiel d'un composant réalisé selon l'invention.

La figure 2 présente une vue d'un ensemble substrat temporaire, couche d'alliage, couche métallique correspondant à une étape intermédiaire du procédé d'encapsulation de composants selon l'invention.

La figure 3 présente une vue d'un ensemble selon la figure 2 d'une pastille montée et raccordée correspondant à une étape ultérieure du procédé d'encapsulation selon l'invention.

La figure 4 présente une vue de dessous d'un composant encapsulé selon l'invention.

La figure 5 présente une vue de dessous d'un composant encapsulé selon une variante de l'invention.

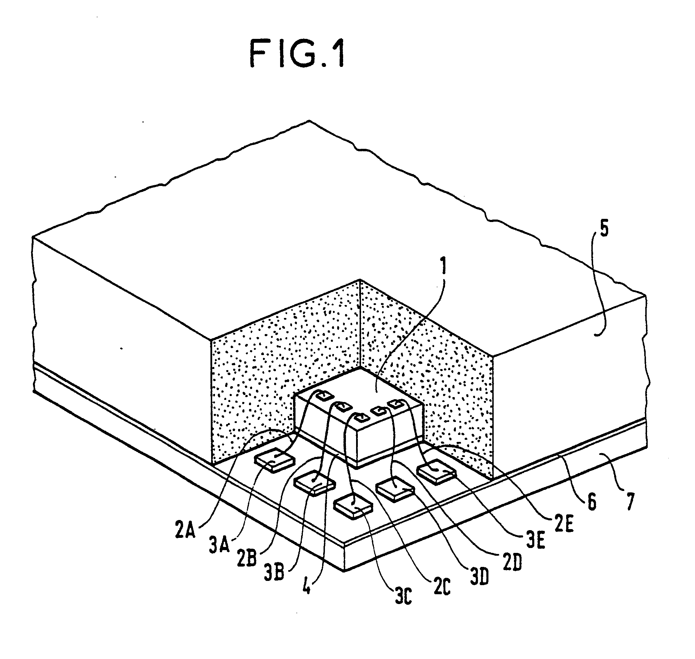

Le composant semi-conducteur présenté à la figure 1 comporte classiquement une pastille ou puce de silicium 1, reliée par des fils conducteurs de liaisons 2, tels 2A, 2B, 2C, 2D, 2E à un réseau de zones métalliques de connexion 3, tels 3A, 3B, 3C, 3D, 3E, qui assurent la mise en liaison électrique des circuits contenus dans la pastille 1 avec l'extérieur du composant. Dans l'exemple présenté une zone métallique 4 préférablement coplanaire avec les zones de connexion 3 assure la mise en liaison thermique de la pastille 1 avec l'extérieur, pour l'évacuation des calories engendrées par le fonctionnement.

La pastille, les fils de liaison 2 et les zones de connexion 3 sont recouvertes par une résine 5 durcie qui assure un isolement électrique et l'immobilisation des fils 2 et de la pastille 1 entre eux et par rapport aux zones de connexion 3 et 4.

La face de ces zones de connexion 3 et 4 destinée à assurer leur connexion avec des liaisons non figurées desservant des circuits extérieurs non figurés, est soudée à une couche conductrice d'alliage à bas point de fusion 6 recouvrant un substrat métallique 7, dit temporaire, assurant une protection des zones de connexion contre les détériorations et les pollutions avant utilisation du composant. La fusion de la couche d'alliage 6 permet le retrait du substrat temporaire 7 ce qui assure la mise à jour des faces des zones de connexion 3 et 4 servant à raccorder le composant avec l'extérieur.

Selon l'invention le procédé d'encapsulation ·est le suivant. En premier lieu on réalise une mince couche conductrice d'alliage à bas point de fusion 6 sur un substrat métallique 7 normalement conducteur.

Le substrat est composé par exemple d'une classique tôle et l'alliage est par exemple du type étain-plomb permettant le soudage et l'étamage des métaux sur lequel on le dépose. Ce dépôt d'alliage peut être effectué par tout moyen approprié, c'est par exemple un dépôt électrolytique d'épaisseur suffisante pour éviter la création d'alliage ternaire du type étain-plomb-cuivre à température de fusion relativement élevée lors de l'étape suivante de constitution des zones de connexion métallique, on choisira par exemple une épaisseur minimale de l'ordre de dix à trente microns.

Cette première étape n'est pas nécessairement directement suivie par les étapes suivantes dans la mesure où il est envisageable d'utiliser des plaques ou un ruban métallique préalablement recouverts d'alliage à bas point de fusion.

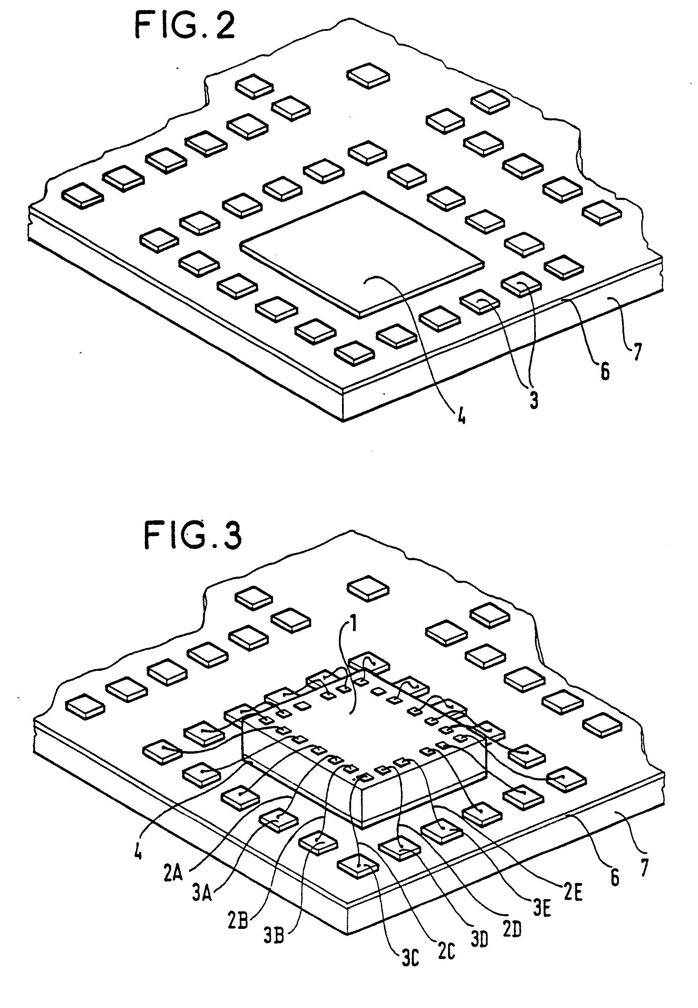

En second lieu on réalise les zones de connexion métallique 3 et 4 sous forme d'un réseau qui est disposé sur la couche d'alliage 6 (figure 2).

Plusieurs techniques sont possibles, une première d'entre elles consiste à utiliser une feuille métallique prédécoupée comportant les différentes zones de connexion 3 et 4 reliées entre elles par des liaisons temporaires non figurées ici que l'on retire après soudage des zones de connexion sur la couche d'alliage. Cette solution permet de réduire notablement la surface occupée par les zones de connexion d'une pastille dans la mesure où l'on peut bénéficier des liaisons temporaires lors du soudage des zones de connexion 3 et 4 sur la couche d'alliage 6 pour résister aux contraintes mécaniques qui seront ensuite supportées par la résine durcie englobant le composant obtenu.

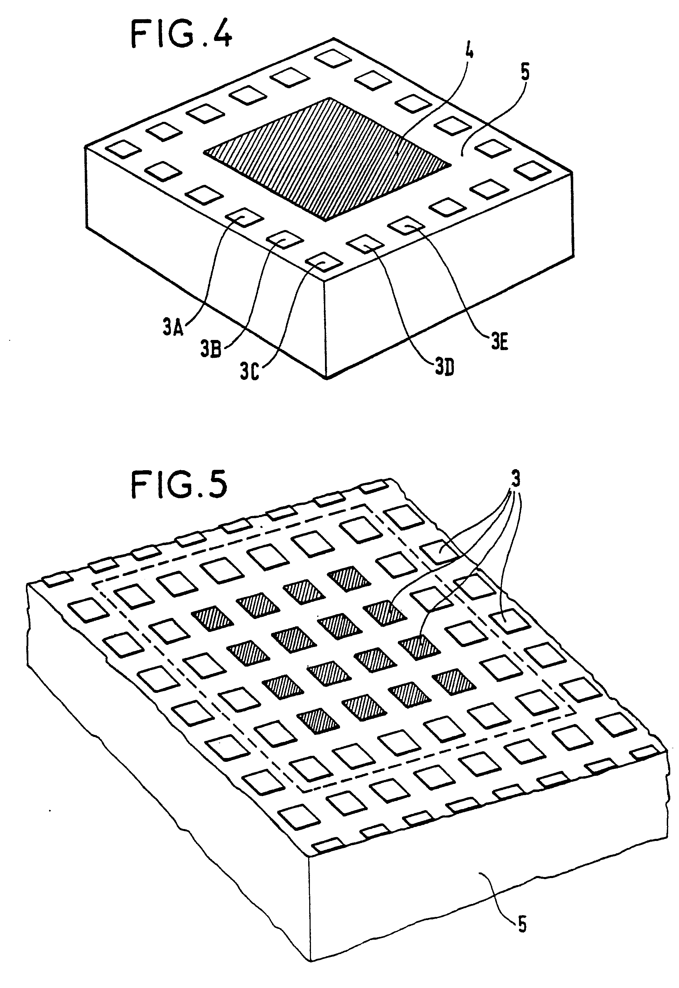

Selon une variante de l'invention le métal destiné à former le réseau métallique de connexion est déposé sur la couche d'alliage 6 portée par le substrat 7. Le réseau est par exemple obtenu par dépôt sélectif, à travers un masque, d'un métal tel que du cuivre ou du nickel ou par enlèvement sélectif d'un dépôt métallique uniforme global selon notamment les techniques de photolithographie. Le résultat obtenu est un réseau métallique disposé préférablement selon un motif répétitif régulier tel que ceux présentés aux figures 4 et 5, permettant la réalisation simultanée et/ou en continu de composants encapsulés selon l'invention. L'épaisseur et les dimensions des plots que constituent les différentes zones de connexion 3 et 4 ainsi que leur écartement sont choisis en fonction des contraintes électriques usuelles, sans qu'interviennent les contraintes mécaniques introduites par l'emploi de réseaux réalisés à partir de feuilles prédécoupées puisque les plots ainsi obtenus sont assujettis au substrat temporaire 7 par la couche d'alliage qui a servi de base à leur réalisation.

Il est donc possible d'utiliser les techniques usuelles en microélectronique pour réaliser un réseau de connexion de taille minimale pour chaque pastille 1 sur le substrat temporaire 7 recouvert d'alliage.

On effectue ensuite la mise en place des pastilles 1 sur leurs zones 4 respectives et leur raccordement électrique aux zones de connexion 3 correspondantes par des fils de liaison 2 telle la pastille 1 sur la zone 4 et avec les zones 3A, 3B ... via les fils de liaisons 2A, 2B ... ainsi que le montre la figure 3. Les moyens utilisés sont ceux habituellement mis en œuvre pour le positionnement et le raccordement de pastilles sur un substrat isolant doté de zones de connexion.

L'enrobage de chaque composant, également réalisé de manière classique s'effectue au moyen d'une résine durcissable 5 coulée ou moulée recouvrant la pastille 1, les fils de liaison 2 et les zones de connexion 3. Le durcissement de cette résine par refroidissement ou polymérisation permet d'assujettir les uns aux autres les différents éléments 1, 2, 3 et 4 de chaque composant.

Après durcissement de la résine 5 la fusion de la couche d'alliage 6 par simple chauffage à relativement basse température permet d'éliminer le substrat métallique temporaire 7 qui a permis la réalisation d'un réseau métallique de connexion de faibles dimensions.

Le retrait du substrat temporaire 7, qui peut s'effectuer soit en fin de procédé de production des composants, soit ultérieurement lors de la mise en œuvre des composants, permet de mettre à jour les faces des zones de connexion 3 et 4 qui sont destinées à la mise en liaison électrique et/ou thermique avec l'extérieur.

Le retrait du substrat temporaire 7 juste avant mise en œuvre présente l'avantage d'assurer la protection contre les détériorations par choc ou frottement et contre les pollutions des zones sur lesquelles les contacts avec l'extérieur seront établis.

La fusion de la couche d'alliage laisse de plus subsister un film d'étamage sur les faces à nu des zones de connexion, ce qui permet d'éviter une opération d'étamage normalement nécessaire au soudage des liaisons venant de l'extérieur non figurées ici.

Ainsi qu'amorcé sur les dessins des figures 2 et 3 généralement on réalise bien entendu simultanément une pluralité de composants et le réseau métallique de connexion présente un motif répétitif régulier préférablement matriciel dans lequel des plots de diffusion thermique 4 dont les dimensions correspondent à celles des pastilles 1 sont respectivement entourés par des zones satellites de connexion 3. Chaque composant est séparé des autres après enrobage dans la résine et durcissement de cette dernière, par sciage ou sectionnement, soit avant soit après retrait du substrat temporaire.

La figure 4 présente une vue d'un tel composant unitaire dont les zones de connexion 3 et 4 ont été mises à nu.

Selon une variante de l'invention, on réalise le réseau métallique de connexion selon un motif régulier composé de plots identiques disposés matriciellement, ainsi que présenté à la figure 5. La zone de diffusion thermique disposée sous la pastille est alors composée d'une pluralité de plots 3 représentés en grisé qui sont identiques au plot de connexion électrique 3 qui les entourent.

Ceci permet d'utiliser le même motif pour différents composants, ce qui présente un intérêt certain s'il est nécessaire de réaliser des petites séries de composants dont les pastilles sont différentes.

## Revendications

1. Procédé d'encapsulation de composants semi-conducteurs et notamment de composants de grande complexité, caractérisé en ce que l'on réalise les zones de connexions (3, 4) destinées à relier chaque composant avec l'extérieur sous forme d'un réseau métallique qui est disposé sur une couche conductrice d'alliage à bas point de fusion (6) recouvrant elle-même un substrat métallique temporaire (7), en ce qu'après mise en place et raccordement de chaque pastille de composant (1) puis immobilisation au moyen d'une résine durcissable (5), on fait fondre la couche d'alliage (6) après durcissage de la résine (5), ce qui permet de retirer le substrat temporaire (7) et de mettre à jour les faces des zones de connexions (3 et 4) qui sont destinées à la mise en liaison électrique et/ou thermique des composants ainsi encapsulés, avec l'extérieur.

2. Procédé d'encapsulation selon la revendication 1, caractérisé en ce que le réseau métallique (3, 4) est obtenu par découpage d'une feuille de métal et qu'il est soudé par chauffage sur la couche d'alliage (6).

3. Procédé d'encapsulation selon la revendication 1, caractérisé en ce que le réseau métallique (3, 4) est obtenu à partir d'un dépôt métallique réalisé sur la couche d'alliage (6) sélectivement ou globalement avec retrait sélectif.

4. Procédé d'encapsulation selon la revendication 1, caractérisé en ce qu'il comporte les phases suivantes :

dépôt de la couche d'alliage à bas point de fusion (6) sur le substrat métallique temporaire (7),

réalisation du dépôt métallique destiné à former le réseau de connexion, sur la couche d'alliage (6),

mise en place et câblage des pastilles (1) sur les zones de connexion (3, 4) du réseau,

recouvrement de chaque composant composé d'une pastille (1) de ses fils de liaison (2) et de ses zones de connexion (3, 4) par moulage ou coulage d'une résine durcissable (5),

durcissement de la résine (5)

dissociation du substrat temporaire (7) et de la couche métallique (3, 4) porteuse de composants par fusion de la couche d'alliage (6) ce qui met à jour les faces, ainsi étamées, des zones de connexion (3, 4) qui sont destinées à la mise en liaison électrique et/ou thermique des composants avec l'extérieur.

5. Procédé d'encapsulation de composants semi-conducteurs selon la revendication 1, caractérisé en ce que le dépôt de la couche métallique (3, 4) s'effectue selon un motif répétitif régulier comprenant une zone centrale (4) pour la diffusion thermique dont les dimensions correspondent à celles de la pastille (1) qu'on vient y appliquer et des zones satellites de connexion (3) disposées autour de la zone centrale, les différentes zones d'un motif définissant un ensemble unitaire mécaniquement séparable par sectionnement, après mise en place de la pastille (1), raccordement des fils de liaison (2) et durcissement de la résine d'encapsulation (5).

6. Procédé d'encapsulation de composants semi-conducteurs selon la revendication 1, caractérisé en ce que le dépôt de la couche métallique s'effectue selon un motif répétitif régulier comprenant une pluralité de plots identiques (3) déposés matriciellement de manière à permettre la création d'une zone de diffusion thermique sous chaque pastille à l'aide de plusieurs plots (3) sur lesquels cette pastille est appliquée et à permettre la connexion des fils de liaison (2) issus de la pastille (1) aux plots (3) entourant cette pastille de manière à ce que l'ensemble unitaire ainsi formé soit mécaniquement séparable par sectionnement après mise en place de la pastille, raccordement des fils de liaison (2) et durcissement de la résine d'encapsulation (5).

7. Procédé d'encapsulation de composants semi-conducteurs selon la revendication 1, caractérisé en ce que l'étamage des zones de connexion avant soudage des connexions émanant de l'extérieur est assuré par la fusion de la couche d'alliage (6) placée entre le substrat temporaire (1) et la couche métallique lors du retrait dudit substrat.

8. Composant semi-conducteur encapsulé comportant au moins une pastille (1) immobilisée dans une résine durcie avec ses fils de liaison (2) à des zones métalliques coplanaires de connexion (3) destinées à assurer sa mise en liaison avec l'extérieur, caractérisé en ce qu'il comporte de plus un substrat métallique temporaire de protection (7) lié aux zones métalliques coplanaires de connexion (3) par une couche d'alliage à bas point de fusion (6), dont la fusion permet de retirer le substrat temporaire et de mettre à jour les faces des zones de connexion qui sont destinées à la mise en liaison électrique et/ou thermique du composant avec l'extérieur.

## Claims

1. A method of encapsulating semiconductor components, and particularly those of a high complexity, characterized in that the connection zones (3, 4) conceived to connect each component with the outside are realized as a metallic network which is disposed on a conducting layer of an alloy having a low melting point (6) and covering a temporary metal substrate (7), that after positioning and connecting each component chip (1) and after its immobilization by means of a hardenable resin (5) and after the hardening of the latter the alloy layer (6) is melted, thus allowing the temporary substrate (7) to be withdrawn and the surfaces of the connection zones (3, 4) to become apparent, which are conceived to connect electrically and/or thermally the encapsulated components with the outside.

2. An encapsulation method according to claim 1, characterized in that the metallic network (3, 4) is obtained by cutting out a metal film and that it is soldered to the alloy layer (6) by heating it.

3. An encapsulation method according to claim 1, characterized in that the metallic network (3, 4) is obtained from a metallic coating on the alloy layer (6) in a selective manner or a global manner followed by selective removing.

4. An encapsulation method according to claim 1, characterized in that it includes the following steps :

depositing the alloy layer having a low melting point (6) on the temporary metal substrate (7), realizing the metal coating conceived to constitute the connection network, on the alloy layer (6),

positioning and wiring the chips (1) on the connection zones (3, 4) of the network,

moulding or pouring a hardenable resin (5) over each component composed of a chip (1), its connection wires (2) and its connection zones (3, 4),

hardening of the resin (5),

separating the temporary substrate (7) and the metal layer (3, 4) bearing the components, by melting the alloy layer (6), thus rendering apparent the tinned connection zones (3, 4) which are conceived to electrically and/or thermally connect the components with the outside.

5. A method for encapsulating semiconductor components according to claim 1, characterized in that the depositing of the metal layer (3, 4) is made according to a regular repetitive pattern comprising a central zone (4) for the thermal diffusion, the dimensions of this zone corresponding to that of the chip (1) which has been applied thereon, and satellite connection zones (3) disposed around the central zone, the different zones of one pattern defining a unit which may be separated mechanically by cutting after positioning of the chip (1), branching of the connection wires (2) and the hardening of encapsulation resin (5).

6. A method for encapsulating semiconductor components according to claim 1, characterized in that the metal layer is deposited according to a regular repetitive pattern comprising a plurality of identical plots (3) in a matrix arrangement such that a thermal diffusion zone is created beneath each chip by means of several plots (3) on which this chip is laid, and that the connection wires (2) originating from the chip (1) are connected to the plots (3) surrounding said chip, so that the resulting unit may be mechanically separated by cutting after positioning of the chip, branching of the connection wires (2) and hardening of the encapsulation resin (5).

7. Method for encapsulating semiconductor components according to claim 1, characterized in that the tinning of the connection zones prior to the soldering of the connections originating from the outside is obtained by diffusion of the alloy layer (6) placed between the temporary substrate (1) and the metal layer during the withdrawal of said substrate.

8. An encapsulated semiconductor component comprising at least one chip immobilized in a hardened resin with its connection wires (2) conceived for the connection with the outside, characterized in that it further comprises a protective temporary metal substrate (7) connected to the coplanar metallic connection zones via an alloy layer of a low melting point (6), the melting of which allows the temporary substrate to be withdrawn and the surfaces of the connection zones to become apparent, which are conceived to electrically and/or thermally branch the component with the outside.

**Patentansprüche**

1. Verfahren zum Einkapseln von Halbleiterbauteilen, insbesondere solchen großer Komplexität, dadurch gekennzeichnet, daß die Anschlußzonen (3, 4), die jedes Bauteil nach außen verbinden sollen, in Form eines metallischen Netzes ausgebildet sind, daß auf einer ein provisorisches Metallsubstrat (7) bedeckenden leitenden Schicht aus einer Legierung mit niedrigem Schmelzpunkt (6) liegt, daß man nach dem Aufbringen und Anschließen jedes Bauteilplättchens (1) und nach dessen Befestigung mithilfe eines härtbaren Harzes (5) die Legierungsschicht (6) nach dem Aushärten des Harzes (5) schmelzen läßt, so daß es möglich wird, das provisorische Substrat (7) zu entfernen und die Flächen der Verbindungszonen (3 und 4) freizulegen, die dazu bestimmt sind, die so eingekapselten Bauteile elektrisch und/oder thermisch nach außen zu verbinden.

2. Einkapselungsverfahren nach Anspruch 1, dadurch gekennzeichnet, daß das metallische Netz (3, 4) durch Ausschneiden aus einer Metallfolie erhalten wird und daß es durch Erhitzen auf die Legierungsschicht (6) aufgelötet wird.

3. Einkapselungsverfahren nach Anspruch 1, dadurch gekennzeichnet, daß das metallische Netz (3, 4) ausgehend von einer Metallabscheidung erhalten wird, die auf die Legierungsschicht (6) selektiv oder global mit anschließender selektiver Entfernung aufgebracht wird.

4. Einkapselungsverfahren nach Anspruch 1, dadurch gekennzeichnet, daß es die folgenden Verfahrensschritte aufweist :

Aufbringen der Legierungsschicht mit niedrigem Schmelzpunkt (6) auf das provisorische metallische Substrat (7),

Herstellung der Metallschicht für das Verbindungsnetz auf der Legierungsschicht (6),

Aufbringen und Verdrahten der Plättchen (1) auf den Verbindungszonen (3, 4) des Netzes,

Bedecken jedes aus einem Plättchen (1), seinen Anschlußdrähten (2) und seinen Verbindungszonen (3, 4) gebildeten Bauteils durch Übergießen mit einem härtbaren Harz (5),

Aushärtung des Harzes (5),

Entfernung des provisorischen Substrats (7) und der die Bauteile tragenden metallischen Schicht (3, 4) durch Schmelzen der Legierungsschicht (6), wodurch die so verzinnten Flächen der Verbindungszonen (3, 4) zutagetreten, die dazu bestimmt sind, die Bauteile elektrisch und/oder thermisch nach außen zu verbinden.

5. Verfahren zur Einkapselung von Halbleiterbauteilen nach Anspruch 1, dadurch gekennzeichnet, daß das Aufbringen der Metallschicht (3, 4) gemäß einem regelmäßigen repetitiven Muster erfolgt, das eine zentrale Zone (4) für die thermische Diffusion und mit Abmessungen, die denen des dort aufgebrachten Plättchens (1) entsprechen, und Satellitenzonen (3) zur Verbindung aufweist, die um die zentrale Zone herum angeordnet sind, wobei die verschiedenen Zonen eines Musters eine mechanisch durch Zerschneiden abtrennbare Einheit nach dem Aufbringen des Plättchens (1), dem Anschluß der Anschlußdrähte (2) und dem Erhärten des Einkapselungsharzes (5) bilden.

6. Verfahren zur Einkapselung von Halbleiterbauteilen nach Anspruch 1, dadurch gekennzeichnet, daß die Abscheidung der Metallschicht gemäß einem repetitiven regelmäßigen Muster erfolgt, das eine Vielzahl von identischen Punkten (3) enthält, welche matrixartig so aufgebracht sind, daß die Bildung einer thermischen Diffusionszone unter jedem Plättchen mithilfe mehrerer Punkte (3) erreicht wird, auf die dieses Plättchen gelegt ist, und daß der Anschluß der von dem Plättchen ausgehenden Anschlußdrähte (2) mit den das Plättchen umgebenden Punkten (3) erreicht wird, so daß die so gebildete Baueinheit mechanisch durch Zerschneiden nach dem Aufbringen des Plättchens, dem Anschluß der Anschlußdrähte (2) und dem Erhärten des Einkapselungsharzes (5) trennbar ist.

7. Verfahren zum Einkapseln von Halbleiterbauteilen nach Anspruch 1, dadurch gekennzeichnet, daß das Verzinnen der Anschlußzone vor dem Anlöten der von außen kommenden Verbindungen durch Schmelzen der zwischen dem provisorischen Substrat (7) und der Metallschicht liegenden Legierungsschicht (6) während des Abziehens des Substrats bewirkt wird.

8. Eingekapseltes Halbleiterbauteil mit mindestens einem in einem gehärteten Harz eingeschlossenen Plättchen (1) und mit seinen Drähten (2) zum Anschluß an koplanare metallische Anschlußzonen (3), die dazu bestimmt sind, die Verbindung nach außen herzustellen, dadurch gekennzeichnet, daß es außerdem ein provisorisches metallisches Schutzsubstrat (7) aufweist, das mit den koplanaren metallischen Verbindungszonen (3) über eine Legierungsschicht mit niedrigem Schmelzpunkt (6) verbunden ist, deren Schmelzen es ermöglicht, das vorübergehende Substrat zu entfernen und die Oberflächen der Verbindungszonen offenzulegen, die dazu bestimmt sind, das Bauteil elektrisch und/oder thermisch nach außen anzuschließen.

# FIG.1

## FIG.2

## FIG.3

# FIG.4

# FIG.5